Europäisches Patentamt

(19) European Patent Office

Office européen des brevets

(11) Numéro de publication: **0 060 752**
**B1**

(12) **FASCICULE DE BREVET EUROPEEN**

(45) Date de publication du fascicule du brevet:
**14.05.86**

(21) Numéro de dépôt: **82400361.0**

(22) Date de dépôt: **02.03.82**

(51) Int. Cl.⁴: **H 01 L 27/14**, H 04 N 3/15

(54) **Dispositif photosensible solide à deux dimensions, et dispositif d'analyse d'image, utilisant le transfert de charges électriques, comportant un tel dispositif.**

(30) Priorité: **13.03.81 FR 8105136**

(43) Date de publication de la demande:
**22.09.82 Bulletin 82/38**

(45) Mention de la délivrance du brevet:
**14.05.86 Bulletin 86/20**

(84) Etats contractants désignés:
**DE FR GB NL**

(56) Documents cités:
**FR - A - 2 367 353**
**US - A - 4 145 803**
**US - A - 4 198 646**
**US - A - 4 200 892**

(73) Titulaire: **THOMSON-CSF, 173, Boulevard Haussmann, F-75379 Paris Cedex 08 (FR)**

(72) Inventeur: **Berger, Jean-Luc, THOMSON-CSF SCPI 173, bld Haussmann, F-75360 Paris Cedex 08 (FR)**
Inventeur: **Descure, Pierrick, THOMSON-CSF SCPI 173, bld Haussmann, F-75360 Paris Cedex 08 (FR)**

(74) Mandataire: **Mayeux, Michèle et al, THOMSON-CSF SCPI 19, avenue de Messine, F-75008 Paris (FR)**

## Description

La présente invention se rapporte au domaine de l'analyse électrique d'images lumineuses utilisant le transfert de charges dans un semiconducteur. Elle concerne plus particulièrement un dispositif photosensible solide à deux dimensions et un dispositif d'analyse d'images mettant en œuvre ce dispositif photosensible.

On connaît différents dispositifs à l'état solide pour l'analyse d'une image lumineuse, qui sont destinés à être utilisés dans une caméra de télévision pour fournir un signal électrique vidéo. Ils se distinguent par le mode de réalisation de la zone photosensible d'une part, et le système de lecture et d'évacuation des charges créées par l'image, d'autre part. Il est également connu d'utiliser des dispositifs à transfert de charges pour réaliser ces différentes fonctions, comme il est décrit par exemple dans l'ouvrage de SEQUIN et TOMPSETT, intitulé: «Charge transfer devices», (pages 152 à 169):

— dans des organisations dites «à transfert de trame» ou «à structure interligne», dans lesquelles le rayonnement lumineux est reçu sur des registres à transfert de charges; dans ces dispositifs, le transfert de charges est réalisé sur de grandes surfaces, ce qui constitue un inconvénient du fait qu'il est actuellement difficile d'obtenir des rendements élevés pour la fabrication de ces grandes surfaces;

— dans des dispositifs dits «CID» (pour «Charge Injection Devices») qui ne présentent pas cet inconvénient mais qui nécessitent en général une réinjection des charges dans le substrat semiconducteur, ce qui présente un certain nombre d'inconvénients, parmi lesquels du bruit ou des difficultés au niveau des valeurs des capacités nécessaires pendant ou après la lecture des charges.

Plus généralement, en sus des problèmes évoqués ci-dessus, se pose la question de la compatibilité d'une part des temps nécessaires à l'intégration lumineuse et d'autre part des temps nécessaires au transfert des charges, dans le cas où cette solution est retenue, avec les temps de balayage de l'écran de télévision qui sont, selon le standard 625 lignes habituel, environ de 52 µs pour le temps d'affichage d'une ligne et de 12 µs pour le temps de retour ligne.

Pour répondre à ces différents impératifs, la Demanderesse a proposé une structure dite «à transfert de ligne», décrite dans la fascicule de brevet EP-B-38 725, qui comporte principalement:

— une matrice de N lignes x M zones ou points, photosensibles, matrice sur laquelle une image à lire est projetée et convertie en charges électriques;

— une mémoire de M points, dite mémoire de ligne, destinée à recevoir successivement les charges signal stockées par chaque ligne;

— un registre à décalage du type CCD (pour «Charge Coupled Devices»), recevant en parallèle le contenu de la mémoire de ligne et délivrant en série le signal électrique d'analyse de l'image.

Par le brevet américain 4 200 892, on connaît un dispositif photosensible solide à deux dimensions qui reçoit une image lumineuse et fournit des signaux électriques d'analyse de cette image, et comporte:

— une pluralité de zones élémentaires photosensibles, réalisées sur un même substrat semiconducteur selon N lignes et M colonnes et isolées les unes des autres, dans lesquelles sont créées des charges électriques en fonction de l'éclairement reçu;

— des moyens de connexion et de commande, assurant la fourniture en parallèle des charges électriques créées dans les M zones photosensibles d'une même ligne, successivement pour les N lignes, ces moyens comportant une pluralité de diodes de lecture, en bande arrangées en colonnes, de façon à recevoir chacune, successivement, sur commande les charges de N zones élémentaires appartenant à N lignes différentes, ces diodes de lecture passant sur l'un des côtés des zones photosensibles;

— des moyens formant écran pour les charges, placés entre chacune des zones photosensibles et les moyens de connexion, ces moyens écran comportant une pluralité de grilles, portées à un potentiel constant, arrangées en colonnes entre les diodes de lecture et les zones photosensibles.

La présente invention se propose de résoudre le problème dû au phénomène bien connu dit de repliement du spectre qui se manifeste lorsque les diodes de lecture passent sur l'un des côtés des zones photosensibles, comme c'est le cas notamment dans le brevet américain 4 200 892. Ce phénomène, ses inconvénients et la solution apportée par l'invention seront décrits dans la description détaillée des figures.

Selon la présente invention, les diodes de lecture sont arrangées selon des colonnes qui traversent chacune des zones photosensibles sensiblement en son milieu.

L'invention est décrite, à titre d'exemple non limitatif, plus en détails dans ce qui suit à l'aide des figures annexées, qui représentent:

— la figure 1, l'organisation générale d'une structure à transfert de ligne;

— la figure 2, un premier mode de réalisation du dispositif photosensible selon l'invention;

— la figure 3, une première coupe du dispositif de la figure 2;

— la figure 4, une deuxième coupe du dispositif de la figure 2;

— la figure 5, une variante du dispositif représenté figure 2;

— la figure 6, un deuxième mode de réalisation du dispositif selon l'invention;

— la figure 7, une première coupe du dispositif représenté figure 6;

— la figure 8, une variante du dispositif représenté figure 6, vue en coupe;

Sur ces différentes figures, les mêmes références se rapportent aux mêmes éléments.

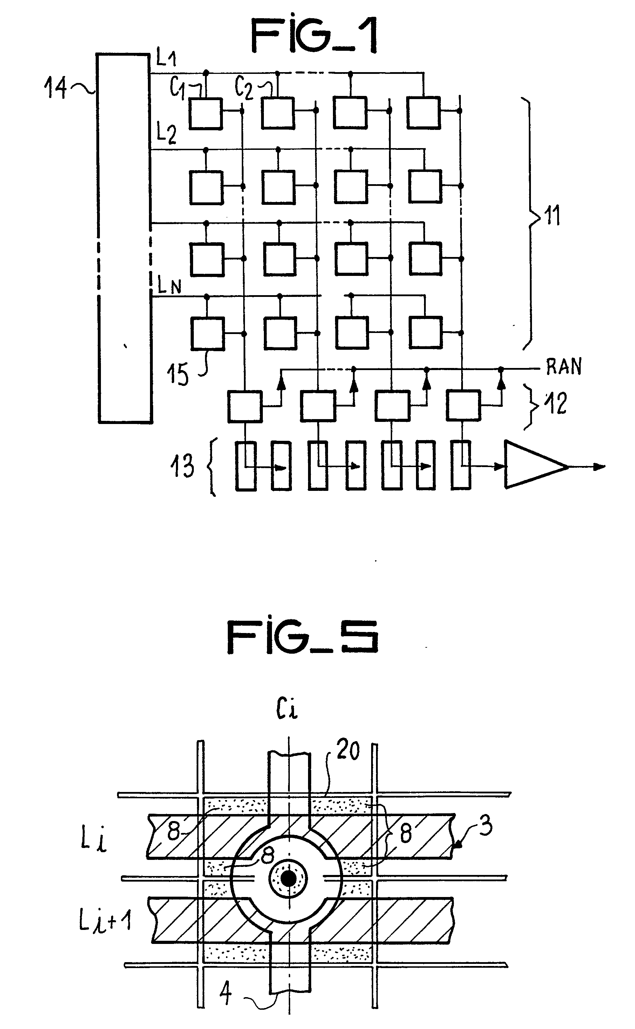

La figure 1 représente donc l'organisation générale d'une structure à transfert de lignes, telle que décrite dans la demande de brevet français précitée.

Cette structure comporte principalement une zone photosensible 11, une mémoire de ligne 12 et un registre à décalage 13, du type CCD.

La zone photosensible reçoit l'image lumineuse à analyser et la transforme en charges électriques. Il est à noter qu'on vise ici par image lumineuse la détection non seulement des longueurs d'onde visibles mais également de celles qui les entourent, notamment dans l'infrarouge. La zone photosensible est constituée par un ensemble de zones élémentaires 15, également appelées ci-dessous points, arrangées en N lignes, repérées $L_1$, $L_2$...$L_N$, et M colonnes, repérées $C_1$, $C_2$...$C_M$. Les points photosensibles d'une même ligne sont reliés entre eux et reliés à un dispositif de commande 14 permettant d'adresser les lignes les unes après les autres, ce dispositif étant constitué par exemple par un registre à décalage du type MOS. Les points photosensibles 11 d'une même colonne sont reliés à une même connexion vers la mémoire de ligne 12.

La mémoire de ligne 12 reçoit donc en parallèle les charges créées dans chacun des points photosensibles 15 d'une même ligne, puis elle les transfère également en parallèle vers le registre 13, qui est un registre à décalage et qui fournit donc l'information en mode série, information qui constitue le signal vidéo d'analyse de l'image optique reçue sur la zone photosensible 11.

L'enchaînement des différentes opérations d'intégration de l'image au niveau de la zone photosensible 11, du transfert des lignes dans la mémoire de ligne, puis du transfert des signaux dans le registre 13, pour les différentes lignes, est maintenant décrit.

Tout d'abord, il est à noter que l'intégration de l'image est réalisée en permanence sur la totalité de la zone photosensible 11, sauf sur celle des lignes qui est adressée par le registre 14.

Pendant le temps de retour ligne, le contenu de la mémoire de ligne 12 est transféré dans le registre à décalage 13, l'entrée de la mémoire de ligne étant alors fermée.

Pendant le temps ligne qui suit, le contenu du registre 13 est évacué en série, la connexion entre la mémoire de ligne 12 et le registre 13 est interrompue; il se produit dans une première phase une remise à niveau des moyens de lecture des points 15, par l'intermédiaire de la connexion repérée RAN sur la figure 1, reliée à la mémoire de ligne 12, et dans une deuxième phase, on opère le transfert de l'une des lignes L de la zone 11 vers la mémoire de ligne 12, la sélection (ou «adressage») d'une ligne étant assurée par le registre 14. L'étape suivante correspond au temps de retour ligne pendant lequel s'opère le déversement du contenu de la mémoire de ligne 12 dans le registre 13, celui-ci ayant été entièrement lue lors de l'étape précédente.

Dans un autre mode de réalisation, la sélection d'une ligne, son transfert dans la mémoire de ligne puis dans le registre à décalage s'effectuent entièrement pendant le temps de retour ligne, le temps de ligne étant réservé à la remise à niveau des moyens de lecture, qui est d'autant meilleure qu'elle est plus longue, et à l'évacuation en série du registre à décalage.

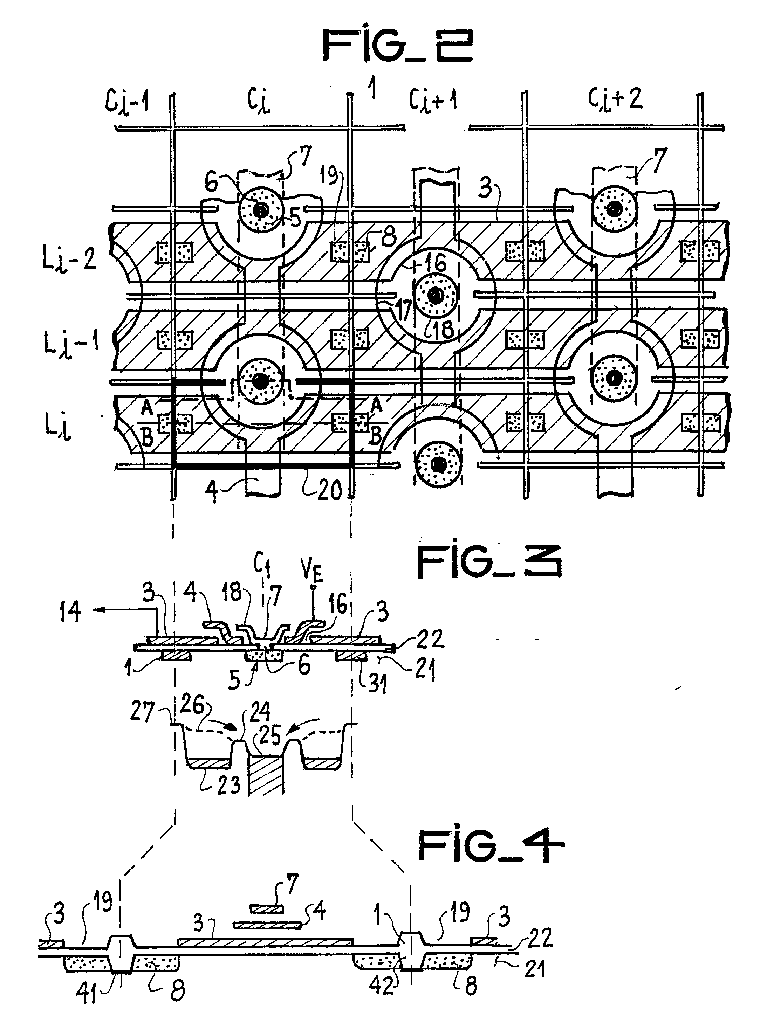

La figure 2 représente un premier mode de réalisation du dispositif photosensible selon l'invention.

Sur cette figure, on a représenté, déposées sur un substrat semiconducteur, silicium par exemple, recouvert d'une couche isolante, par exemple oxyde de silicium, plusieurs dépôts conducteurs, appelés ci-dessous comme les autres dépôts conducteurs électrodes ou grilles, métalliques éventuellement semi-transparents ou en silicium polycristallin, parallèles, représentant les lignes L ($L_{i-2}$, $L_{i-1}$, $L_i$ sur la figure) du dispositif selon l'invention, et constituant avec le substrat semiconducteur et l'isolant, des capacités MOS photodétectrices. Ces grilles présentent des encoches sensiblement en forme d'arcs de cercle, repérées 16 sur la figure, situées alternativement d'un côté et de l'autre de chacune des lignes, les encoches de deux lignes adjacentes se faisant face. Selon les colonnes C du dispositif ($C_{i-1}$, $C_i$, $C_{2+1}$, $C_{i+2}$ sur la figure), sont placées des électrodes, ou grilles 4, portées à un potentiel constant, qui constituent un écran pour les charges, selon un processus décrit plus en détails ci-dessous; chacune des grilles écran 4 est en forme de bande et présente des élargissements 17, sensiblement circulaires, au niveau des encoches 16 et les recouvrant.

Les différentes lignes L, matérialisées par les grilles 3, et colonnes C, matérialisées par les girlles 4, sont séparées les unes des autres par deux séries de barrières d'isolement 1, représentées sur la figure en doubles traits, respectivement parallèles aux lignes et aux colonnes; cet isolement s'interrompt au niveau des élargissements 17. Chacune des barrières d'isolement 1 peut être réalisée soit par une surépaisseur d'oxyde, soit par un surdopage du substrat du même tpye de conductivité que celui-ci (par exemple surdopage $P^+$ pour un substrat P), soit par un cumul des deux solutions, le surdopage intervenant sous la surépaisseur d'oxyde. Le quadrilatère formé par l'intersection des barrières d'isolement 1 constitue un point photosensible dont la capacité est déterminée par la portion de grilles 3 de couche isolante 22 et de substrat 21 entre deux barrières d'isolement 1. A titre d'exemple, l'un de ces points, repéré 20 sur la figure, à l'intersection de la ligne $L_i$ et de la colonne $C_i$, a été souligné en trait épais.

Les grilles 4 présentent une ouverture 18 au centre des élargissements circulaires 17, dans chacune desquelles est réalisée par dopage par exemple une diode 5 qui constitue la diode de lecture du point photosensible considéré. Il est à noter que, dans le mode de réalisation décrit sur la figure 2, les diodes de lecture 5 sont communes à deux points photosensibles et sont disposées en quinconce, d'une colonne à l'autre.

Enfin, représentée en pointillés sur la figure, est déposée une électrode 7 par colonne, sensiblement en forme de bande, au-dessus des diodes de lecture 5, et présentant une zone de contact 6 avec les diodes 5, figurées au centre de ces diodes. Cette électrode a la double fonction de réaliser la connexion électrique des diodes d'une même colonne et de constituer un écran opaque aux rayonnements lumineux qui seraient susceptibles de créer des charges parasites dans les diodes de lecture 5.

La figure 3 illustre une vue en coupe faite selon une ligne AA dans le point photosensible 20, la ligne de coupe passant à la fois par la grille 3, la grille 4, la diode 5, la métallisation 7 et son point de contact 6 avec la diode 5, et les barrières d'isolement 1.

Sur cette figure 3, la structure du dispositif de la figure 2 apparaît plus clairement: il est réalisé dans un substrat semiconducteur 21 deux barrières d'isolement 1 verticales, par exemple par surdopage (zones 31) dans l'exemple représenté, et une diode de lecture 5 au centre du point photosensible, réalisée également par dopage du substrat. Le substrat est recouvert d'une couche isolante 22. Sur la couche 22 est déposée la grille des capacités MOS 3 recouvrant les barrières d'isolement 1 et laissant une ouverture 16 au milieu de la figure 3. La grille écran 4 est placée sur la couche isolante 22 à la périphérie de l'ouverture 16, et s'étend au-desus de la grille 3, séparée de cette dernière bien entendu par une couche d'isolant, non représentée sur cette figure pour la clarté du dessin. La grille écran 4 laisse une ouverture 18 en son centre, permettant à la connexion 7 de venir, à travers l'ouverture 6 de l'isolant 22, en contact électrique avec la diode de lecture 5; l'électrode 7 recouvre à la fois une partie de l'isolant 22 et une partie de la grille écran 4, bien entendu par l'intermédiaire d'une couche isolante entre les grilles 4 et 7, non représentée sur le schéma de la figure 3.

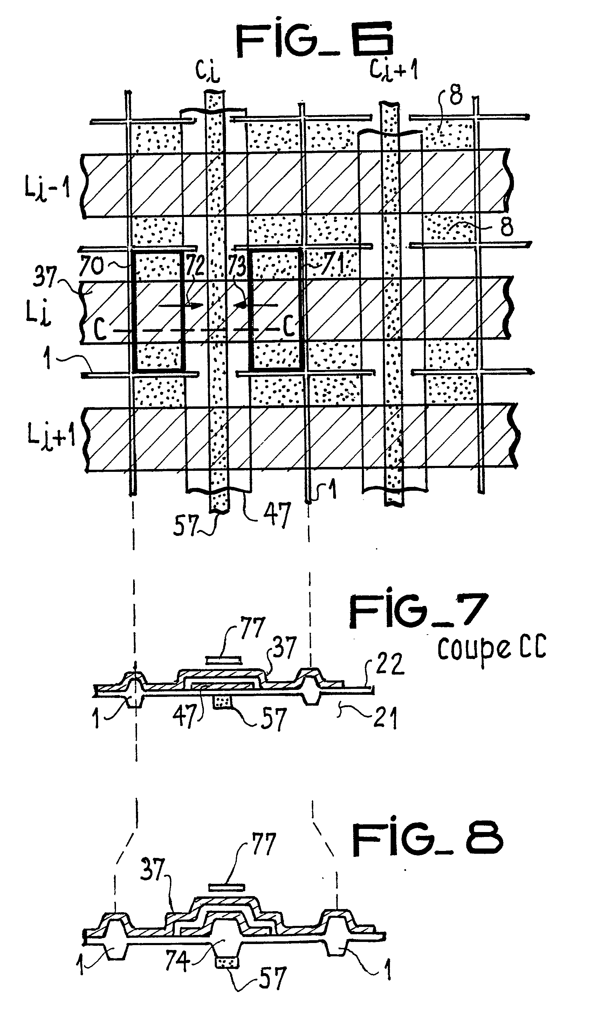

Dans ce mode de réalisation, le dispositif comporte en outre des photodiodes 8, réalisées par dopage du substrat semiconducteur et placées, comme représenté sur la figure 2, dans des ouvertures 19 des grilles des capacités MOS 3, ces diodes 8 étant placées à cheval sur chacune des colonnes d'isolement 1, pour chacun des points photosensibles élémentaires tels que 20, ce qui veut dire que chaque point photosensible comporte deux demi-diodes 8. Dans une variante de réalisation non représentée, la zone occupée par les photodiodes 8 n'est pas limitée à la surface représentée sur la figure 2, mais étendue à toute la surface occupée par les grilles 3 afin d'améliorer le couplage capacité-diode. Dans une autre variante représentée sur la figure 5, où on retrouve à part les photodiodes 8 les mêmes éléments que sur la figure 2 pour deux points photosensibles, les diodes 8 sont alors placées entre les grilles 3 et les barrières d'isolement 1, qui doivent dans ce cas être réalisées par une surépaisseur d'oxyde afin de permettre la réalisation des diodes par autopositionnement des diffusions par rapport à cet isolement d'une part, et aux grilles 3 et 4 d'autre part. Dans ce dernier cas, chacun des points photosensibles comporte quatre photodiodes 8.

Le fonctionnement du dispositif représenté sur les figures 2 et 3 sera plus clairement expliqué à l'aide du profil du potentiel de surface qui est représenté sous la coupe de la figure 3.

Sur ce diagramme, les potentiels sont représentés croissants vers le bas du schéma, ce qui correspond au fait que, appliqués sur une électrode, ils créent un puits de potentiel permettant d'emprisonner des charges.

Lorsqu'une ligne n'est pas adressée par le registre 14 de la figure 1, son potentiel est à une valeur donnée représentée par la ligne 23 sur le schéma de la figure 3, au droit de la grille de la capacité MOS 3, limité de part et d'autre par des potentiels plus faibles: un potentiel représenté par une ligne 27, correspondant aux barrières d'isolement 1, et un potentil $V_E$ constant appliqué à la grille écran 4, dont la valeur est choisie plus faible que la valeur appliquée à la grille 3 de façon à former un puits de potentiel sous la grille 3, dans lequel les charges créées par l'éclairement peuvent être stockées (zone hachurée sur la figure). Au centre du schéma, au droit de l'électrode 7, le potentiel est, avant la lecture du point photosensible considéré, ramené à une valeur donnée illustrée par le niveau 25 par les moyens de remise à niveau schématisés sur la figure 1, la valeur de ce potentiel devant être plus élevé que le potentiel $V_E$ afin qu'il n'y ait pas invasion par des charges parasites des puits de potentiels situés au droit des grilles 3. Lorsque le point photosensible considéré est, en même temps que tous les points photosensibles de la ligne à laquelle il appartient, sélectionné par le registre 14, le potentiel qui est appliqué à la grille 3 est ramené à une valeur proche de zéro, ce qui est illustré par la ligne 26 sur la figure 3: ce potentiel étant alors inférieur à $V_E$, les charges accumulées lors de la phase précédente sont donc déversées dans la zone centrale pour être évacuées par la connexion 7, comme indiqué par une flèche sur la figure 3.

Il ressort de ce qui précède que, lorsque la ligne n'est pas adressée par le registre 14, les charges créées par l'éclairement s'accumulent dans le puits 23 au droit de l'électrode 3, pendant que s'effectue une remise à niveau du potentiel des diodes de lecture 5; lorsque la ligne est sélectionnée, les charges précédemment accumulées se déversent sur les connexions 7 et le dispositif fournit alors en parallèle les charges correspondant à l'éclairement reçu sur la ligne considérée.

La figure 4 représente une coupe du dispositif représenté figure 2, faite parallèlement à la coupe AA précédente, mais au niveau des photodiodes 8 selon la ligne BB représentée sur la figure 2.

Sur cette figure, on retrouve le substrat semiconducteur 21 recouvert d'une couche d'isolant 22. Sur la couche 22 est déposée la grille 3 qui comporte deux ouvertures 19 au droit des photodiodes 8 réalisées par dopage du substrat 21.

A titre d'exemple, les barrières d'isolement verticales 1 ont été représentées sur cette figure selon un autre mode de réalisation possible, à savoir une surépaisseur 42 d'isolant, la surépaisseur s'étendant à la fois dans le substrat 21 et au-dessus du reste de la surface isolante 22. L'isolation 1 peut être renforcée par un surdopage 41 réalisé dans le substrat sous la surépaisseur d'oxyde, ce surdopage étant analogue au surdopage 31 de la figure 3. Au-dessus de la grille 3, on trouve la grille écran 4 et enfin l'électrode de colonne 7, ces différentes électrodes étant séparées les unes des autres par des couches d'isolant non représentées.

La structure de la figure 2 réalise donc l'association, au niveau de chaque point photosensible, d'une capacité MOS (substrat 21, isolant 22 et électrode 3) constituant une première zone de collection de charges, avec une seconde zone de collection de charges, dans laquelle on a réalisé dans ce mode de réalisation une photodiode 8. En effet, la capacité MOS a une capacité de stockage des charges grande et permet ainsi d'obtenir une bonne dynamique pour chaque point photosensible; la seconde zone de collection des charges permet de s'affranchir de l'absorption des faibles longueurs d'onde qui se produit dans la grille de la capacité; de plus, la diode 8 réalisée dans cette zone de collection, non obligatoire pour le fonctionnement du dispositif, permet d'accroître la sensibilité de la zone photosensible. En outre, les diodes de lecture placées en quinconce permettent d'uniformiser la résolution verticale. De plus, l'électrode de colonne 7 qui collecte les charges repose sur une grille écran (4), portée à un potentiel fixe, qui l'isole de toute influence parasite.

On parle de repliement du spectre, par exemple, lorsqu'on utilise un dispositif photosensible où les points photosensibles sont répartis de façon périodique et séparés par une distance D.

Si l'on appelle d l'ouverture du point photosensible (c'est-à-dire sa dimension selon un axe où les points photosensibles sont séparés par une distance D), la courbe donnant l'amplitude du signal lumineux en fonction de la fréquence spatiale est maximale pour o, puis nulle à 1/d, 2/d, 3/d...

Par ailleurs, à cause de l'échantillonnage, il y a superposition d'une réponse en fréquence parasite qui est constituée par le repliement du spectre déjà décrit, c'est-à-dire par un spectre maximal pour 1/D et s'annulant à 1/D − 1/d, puis 1/D − 2/d...

Ce phénomène de repliement du spectre se révèle d'autant plus gênant que la distance D entre deux points photosensibles est grande devant l'ouverture d du point.

Ainsi lorsque les colonnes collectrices sont sur l'un des bords des points photosensibles la distance D entre deux points voisins est supérieure à l'ouverture d du point photosensible, à cause de la présence des zones opaques dues aux électrodes 7.

Par contre, lorsque les colonnes collectrices sont au centre des points photosensibles, comme sur la figure 3, on augmente l'ouverture d du point photosensible car il y a chevauchement entre chaque zone photosensible et les deux zones qui l'entourent dont elle n'est séparée que par une barrière d'isolement 1 et non un écran opaque.

L'augmentation de l'ouverture d des points photosensibles par rapport à la distance D entre deux points voisins permet de diminuer les inconvénients dus au repliement du spectre.

La figure 6 représente un deuxième mode de réalisation du dispositif suivant l'invention dans lequel les géométries ont été simplifiées afin de permettre des dimensions plus petites et, donc, la réalisation d'une zone photosensible de plus haute résolution.

Le dispositif représenté sur la figure 6, dont on donne figure 7 une vue en coupe selon une ligne CC, comporte des capacités MOS constituées par des bandes conductrices 37 rectangulaires, sans encoches contrairement aux modes de réalisation précédents, déposées sur le substrat semiconducteur 21 recouvert d'une couche d'isolant 22; ces grilles sont séparées les unes des autres par des barrières d'isolement horizontales 1, réalisées par surépaisseur d'isolant, renforcée éventuellement de surdopage comme décrit ci-dessus. Le dispositif comporte encore des bandes d'isolement 1 verticales limitant les colonnes ($C_i$, $C_{i+1}$ sur la figure). Au milieu de chacune des zones limitées par les bandes d'isolement, est réalisée une diode 57, par diffusion dans le substrat 21, s'étendant sur toute la longueur de la colonne, des barrières d'isolement 1 horizontales s'interrompant au niveau de cette diffusion; cette dernière est comme précédemment recouverte par la grille écran repérée maintenant 47, déposée sur la couche d'isolant 22, la grille 37 étant déposée sur une couche d'isolant (non représentée) déposée elle-même sur la grille 47 comme le montre la figure 8. Comme précédemment, le dispositif comporte encore une métallisation 77, représentée seulement sur la figure 8, recouvrant la grille 37 au niveau de la diode 57, dont la fonction n'est plus ici de collecter les charges mais uniquement de constituer un écran opaque entre l'image lumineuse et la diode 57.

La zone comprise entre deux barrières d'isolement consécutives, horizontalement et verticalement, délimite ainsi deux demi-zones photosensibles 70 et 71 soulignées par un trait plus épais, constituant la zone photosensible de la colonne $C_i$ et de la ligne $L_i$: ces deux demi-zones 70 et 71 déversent en effet leurs charges dans le sens indiqué respectivement par les flèches 72 et 73, dans une même diode de lecture 57.

La figure 8 représente une variante du dispositif de la figure 6, vue en coupe, permettant de réduire la capacité de la colonne collectrice, cette capacité étant un paramètre important dont la réduction permet d'améliorer la rapidité et l'efficacité du transfert.

La seule différence que la figure 8 présente par rapport à la figure 7 est la réalisation d'une surépaisseur d'isolant 74 au-dessus de la diode 57, réalisée par exemple par une oxydation localisée, délimitée par du nitrure de silicium par exemple, selon une technologie connue, faite après la diffusion de la zone 57 et juste au-dessus d'elle. La grille écran 47 est alors déposée sur cette surépaisseur 74 et de part et d'autre de celle-ci, et la grille 37, comme précédemment par-desus la grille écran 47, la métallisation 77 venant encore au-dessus de la grille 37, au niveau de la diffusion 57.

Cette configuration permet de réduire sensiblement la capacité entre les éléments 57 et 47.

Le dispositif de la figure 6 présente par rapport à un dispositif tel que celui décrit par le brevet américain 4 200 892 où les diodes de lecture en bande passent sur l'un des côtés des zones photosensibles l'avantage de diminuer fortement les inconvénients dus au repliement du spectre, comme cela a été expliqué précédemment.

Dans les différents modes de réalisation et variantes mentionnés ci-dessus, il est possible de supprimer les photodiodes 8, leur fonction de collection des charges créées par l'éclairement étant remplie par le substrat lui-même; cette variante présente une plus grande simplicité de réalisation, au détriment de la sensibilité du dispositif.

En pratique, la structure telle que décrite figure 6, permet un pas de points photosensibles très réduit tout en conservant une surface photosensible importante (environ 70% de la surface totale) par rapport à la surface opaque nécessaire à la lecture.

L'inconvénient des structures décrites figures 6, 7 et 8, où les diodes de lecture sont en bande est que les capacités des colonnes collectrices sont bien supérieures à celles des structures décrites figures 2 à 5, où les diodes de lecture sont discrètes.

Ainsi, dans le cas de la figure 8, malgré la surépaisseur d'isolant au-dessus de la diode 57, la diode en bande 57 a une capacité importante par rapport au substrat et à la grille-écran 47 que la recouvre. En effet, il ne faut pas mettre une épaisseur d'oxyde importante entre la grille-écran 47 et la diode 57 pour que la grille-écran remplisse bien sa fonction d'écran.

On obtient ainsi, par exemple, lors de la lecture du signal une quantité de charges de 0,1pC sur une capacité de 10 pF, donc une variation de potentiel très faible.

Par contre dans le cas des figures 2 et 3, on réduit au minimum la surface des diodes 5 et donc leur capacité. De plus, les grilles-écran 4 ne s'étendent pas au-dessus des diodes 5 et les électrodes 7 qui relient les diodes et servent d'écran au rayonnement lumineux peuvent être très éloignées des grilles-écran 4.

La capacité de l'ensemble des diodes discrètes d'une colonne est ainsi, par exemple, cinq fois plus faible que celle d'une diode en bande, dans un cas d'utilisation en télévision, 580 lignes. La lecture du signal se trouve améliorées.

Par ailleurs, la technologie de réalisation des diodes discrètes est plus facile que celle des diodes en bandes.

## Revendications

1. Dispositif photosensible solide à deux dimensions, recevant une image lumineuse et fournissant des signaux électriques d'analyse de cette image, comportant:

— une pluralité de zones photosensibles élémentaires (11), réalisées sur un même substrat semiconducteur selon N linges ($L_i$, $L_{i-1}$...) et M colonnes ($C_{i-1}$, $C_i$, $C_{i+1}$...) et isolées les unes des autres, dans lesquelles sont créées des charges électriques en fonction de l'éclairement reçu;

— des moyens de connexion et de commande, assurant la fourniture en parallèle des charges électriques créées dans les M zones photosensibles d'une même ligne, successivement pour les N lignes, ces moyens comportant une pluralité de diodes de lecture (5, 57) arrangées en colonnes et qui reçoivent chacune successivement sur commande les charges de zones élémentaires;

— des moyens formant écran pour les charges, placés entre chacune des zones photosensibles et les moyens de connexion, ces moyens écran comportant une pluralité de grilles (4, 47), portées à un potentiel constant, arrangées en colonnes entre les diodes de lecture et les zones photosensibles, caractérisé en ce que les diodes de lecture (5, 57) sont arrangées selon des colonnes qui traversent chacune des zones photosensibles — sensiblement en son milieu.

2. Dispositif photosensible selon la revendication 1, caractérisé en ce que chacune des zones photosensibles élémentaires comporte une capacité MOS constituant une première zone de collection de charges, comportant une grille (3) commune aux capacités d'une même ligne, et une seconde zone de collection de charges (8), électriquement couplée à la capacité.

3. Dispositif selon l'une des revendications 1 ou 2, caractérisé en ce que les diodes de lecture (5) sont des diodes dicrètes qui reçoivent chacune successivement sur commande les charges de deux zones élémentaires appartenant à deux lignes différentes.

4. Dispositif selon la revendication 3, caractérisé par le fait que les moyens formant écran comportent une grille (4) par colonne, en forme de bande présentant une série d'élargissement et une ouverture sensiblement au milieu de l'élargissement, les diodes de lecture, (5) formées dans le substrat semiconducteur, étant placées dans chacune des ouvertures.

5. Dispositif selon la revendication 4, caractérisé par le fait que les moyens de connexion et de commande comportent en outre une bande conductrice (7) opaque à l'image lumineuse, déposée pour chaque colonne au-dessus de la grille écran, de largeur au moins égale à celle des diodes de lecture, et assurant la connexion électrique des diodes de lecture discrètes disposées selon une même colonne.

6. Dispositif selon l'une des revendications 1 à 5, caractérisé par le fait que les diodes de lecture (5) sont placées en quinconce.

7. Dispositif selon l'une des revendications 4 à 6, caractérisé par le fait que les grilles écran (4) traversent chacune des zones photosensibles sensiblement en son milieu.

8. Dispositif photosensible selon la revendication 1, caractérisé en ce que les diodes de lecture sont des diodes en bande (57), qui reçoivent chacune successivement, sur commande, les charges de M zones élémentaires appartenant à N lignes différentes, ces diodes de lecture étant formées dans le substrat semiconducteur sous chacune des grilles écran (47) et ayant une plus faible largeur que ces dernières.

9. Dispositif selon la revendication 8, caractérisé par le fait qu'il comporte de plus une bande (77) opaque à l'image lumineuse, de largeur au moins égale à celle des diodes de lecture, déposée au-dessus de la grille écran, pour chacune des colonnes.

10. Dispositif selon l'une des revendications 4 ou 8, caractérisé par le fait que l'isolement des zones photosensibles les unes par rapport aux autres est réalisé verticalement de façon continue entre deux grilles écran, sensiblement au milieu de l'intervalle, et horizontalement (20) entre deux grilles de capacité MOS, de façon continue sauf au niveau des diodes de lecture.

11. Dispositif selon la revendication 10, caractérisé par le fait que l'isolement comporte une surépaisseur (1) de la couche isolante recouvrant le substrat semiconducteur.

12. Dispositif selon la revendication 10, caractérisé par le fait que l'isolement comporte un surdopage (57) du substrat semiconducteur.

13. Dispositif selon la revendication 11, caractérisé par le fait que l'isolement comporte en outre un surdopage du substrat situé sous la surépaisseur.

14. Dispositif selon l'une des revendications précédentes, caractérisé par le fait que chacune des secondes zones de collection des charges (8) est constituée par une diode.

15. Dispositif selon la revendication 14, caractérisé par le fait que la diode s'étend en outre sous la grille de la capacité MOS de chacune des zones photosensibles.

16. Dispositif selon l'une des revendications 4 ou 8, ou selon l'ensemble des revendications 4 et 14 ou 8 et 14, caractérisé par le fait que chaque zone photosensible comporte deux zones de collection des charges, situées dans deux ouvertures pratiquées dans la grille de la capacité MOS, là où elle n'est pas recouverte par la grille écran.

17. Dispositif selon l'une des revendications 1 à 15, caractérisé par le fait que chaque zone photosensible comporte des zones de collection des charges situées aux emplacements de la zone photosensible laissés libres par la grille écran et la grille de la capacité MOS.

18. Dispositif selon l'une des revendications précédentes, caractérisé par le fait que les moyens de connexion et de commande comportent des moyens d'adressage des N lignes, assurant à l'une seulement des N grilles de capacités MOS l'application d'un potentiel autorisant le transfert des charges de la capacité MOS et des zones de collection des charges vers les diodes de lecture.

19. Dispositif selon l'une des revendications 5 ou 9, caractérisé par le fait que la bande opaque à l'image lumineuse (7, 77) est réalisée en aluminium.

20. Dispositif d'analyse d'image, utilisant le transfert de charges électriques, comportant:
— une matrice de N lignes x M zones élémentaires photosensibles;
— une mémoire de M points, dite mémoire de ligne, recevant successivement les charges stockées par chaque ligne;
— un registre à décalage, recevant en parallèle le contenu de la mémoire de ligne et délivrant en série un signal électrique constituant le signal d'analyse de l'image, ce dispositif étant caractérisé par le fait que la matrice photosensible comporte un dispositif selon l'une des revendications précédentes.

**Claims**

1. A two-dimensional photosensitive solid state device receiving a light image and emitting electrical image analysis signals, this device comprising:
— a plurality of elementary photosensitive zones (11) arranged on a common semiconductor substrate on N lines ($L_i$, $L_{i-1}$ ...) and M columns ($C_{i-1}$, $C_i$, $C_{i+1}$ ...), these zones being insulated from one another, electrical charges being created in these zones depending upon the received light;
— connecting and control means delivering parallelly electrical charges created in the M photosensitive zones of the same line, and this successively for the N lines, said means comprising a plurality of reading diodes (5, 57) arranged in columns and each receiving successively on order the charges of elementary zones;
— means forming a charge screen arranged between each one of the photosensitive zones and the connection means, these screen means comprising a plurality of grids (4, 47), brought to a constant potential and arranged in columns between the reading diodes and the photosensitive zones, characterized in that the reading diodes (5, 57) are arranged in columns which pass each through photosensitive zones, substantially in their center.

2. A photosensitive device, characterized in that each one of the elementary photosensitive zones comprises a MOS capacitor constituting a first charge collection zone and comprising a grid (3) which is common to the capacitors of the same line, and a second charge collection zone (8) which is electrically coupled to the capacitor.

3. A device according to one of claims 1 or 2, characterized in that the reading diodes (5) are distinct diodes, each of which receives successively on order the charges of two elementary zones belonging to two different lines.

4. A device according to claim 3, characterized in that the means forming screen comprise one grid (4) per column in the shape of a strip presenting a series of enlargements and an opening substantially in the center of this enlargement, the reading diodes (5) realized in the semiconductor substrate being located in each one of these openings.

5. A device according to claim 4, characterized in that the connecting and control means further comprise a conducting strip (7) which is opaque to the light image, said strip being for each column deposited above the screen grid and having a width at least equal to that of the reading diodes and ensuring the electrical connection of the distinct reading diodes of the same column.

6. A device according to one of claims 1 to 5, characterized in that the reading diodes (5) are placed alternately in rows.

7. A device according to one of claims 4 to 6, characterized in that each one of the screen grids (4) passes through photosensitive zones substantially in their center.

8. A photosensitive device according to claim 1, characterized in that the readin diodes are strip diodes (57), each one receiving successively on order the charges of M elementary zones belonging to N different lines, these reading diodes being formed in the semiconductor substrate under each one of the screen grids (47) and having a smaller width than the latters.

9. A device according to claim 8, characterized in that it further comprises a strip (77), opaque to the light image, of a width which is at least equal to that of the reading diodes, and which is deposited above the screen grid for each one of the columns.

10. A device according to one of claims 4 or 8, characterized in that the insulation of the photosensitive zones from one another is made vertically in a continuous manner between two screen grids substantially in the center of the interval, and horizontally (20) between two MOS capacitor grids in a continuous manner except at the level of the reading diodes.

11. A device according to claim 10, characterized in that the insulation comprises an increased thickness (1) of the insulating layer coating the semiconductor substrate.

12. A device according to claim 10, characterized in that the insulation comprises an overdoping (57) of the semiconductor substrate.

13. A device according to claim 11, characterized in that the insulation further comprises an overdoping of the substrate located under the increased thickness.

14. A device according to one of the preceding claims, characterized in that each one of the second charge collection zones (8) is constituted by a diode.

15. A device according to claim 14, characterized in that the diode further extends under the grid of the MOS capacitor of each one of the photosensitive zones.

16. A device according to one of claims 4 or 8 or according to the assembly of claims 4 and 14 or 8 and 14, characterized in that each photosensitive zone comprises two charge collection zones situated in two openings provided in the grid of the MOS capacitor at the site where said capacitor is not covered by the screen grid.

17. A device according to one of claims 1 to 15, characterized in that each photosensitive zone comprises charge collection zones situated at the sites of the photosensitive zones which are left free be the screen grid and the MOS capacitor grid.

18. A device according to one of the preceding claims, characterized in that the connection and control means comprise means for addressing the N lines, ensuring to only one of the N grids of the MOS capacitors, the application of a potential which allows the transfer of charges from the MOS capacitors and the charge collection zones towards the reading diodes.

19. A device according to one of claims 5 or 9, characterized in that the strip (7, 77) which is opaque to the light image is made of aluminium.

20. An image analysis device using the electrical charge transfer and comprising:
  – a matrix of N lines of M elementary photosensitive zones;
  – a memory of M points, called line memory, successively receiving the charges stored by each line;
  – a shift register receiving parallelly the contents of the line memory and furnishing in series an electrical signal constituting the image analysis signal, this device being characterized by the fact that the photosensitive matrix comprises a device according to one of the preceding claims.

**Patentansprüche**

1. Zweidimensionale lichtempfindliche Festkörperanordnung, der ein Lichtbild zugeführt wird und die elektrische Analysesignale dieses Bildes liefert, mit:
  – einer Vielzahl von elementaren lichtempfindlichen Zonen (11), die auf einem gemeinsamen Halbleitersubstrat gemäss N Zeilen ($L_i$, $L_{i-1}$ ...) und M Spalten ($C_{i-1}$, $C_i$, $C_{i+1}$ ...) isoliert voneinander angeordnet sind, wobei in diesen Zonen elektrische Ladungen abhängig von der empfangenen Belichtung erzeugt werden;
  – Mitteln zum Anschluss und zur Steuerung, die die in den M lichtempfindlichen Zonen einer Zeile erzeugten elektrischen Ladungen parallel und Zeile nach Zeile liefern und eine Vielzahl von Lesedioden (5, 57) aufweisen, die in Spalten angeordnet sind und je nacheinander aufgrund der Steuerung die Ladungen von Elementarzonen empfangen;
  – Mitteln, die einen Schirm für die Ladungen bilden und zwischen jeder der lichtempfindlichen Zonen und den Verbindungsmitteln liegen, wobei diese Schirmmittel eine Vielzahl von Gittern (4, 47) aufweisen, die auf ein konstantes Potential gebracht sind und zwischen den Lesedioden und den lichtempfindlichen Zonen in Spalten angeordnet sind, dadurch gekennzeichnet, dass die Lesedioden (5, 57) in Spalten angeordnet sind, die jede der lichtempfindlichen Zonen im wesentlichen in deren Mitte durchqueren.

2. Lichtempfindliche Vorrichtung nach Anspruch 1, dadurch gekennzeichnet, dass jede der lichtempfindlichen Elementarzonen einen MOS-Kondensator, der eine erste Ladungssammelzone bildet und ein Gitter (3) aufweist, das allen Kondensatoren einer Zeile gemeinsam ist, und eine zweite Ladungssammelzone (8) aufweist, die elektrisch mit dem Kondensator gekoppelt ist.

3. Vorrichtung nach einem der Ansprüche 1 oder 2, dadurch gekennzeichnet, dass die Lesedioden (5) diskrete Dioden sind, die je nacheinander aufgrund der Steuerung die Ladungen zweier zwei verschiedenen Zeilen angehörender Elementarzonen empfangen.

4. Vorrichtung nach Anspruch 3, dadurch gekennzeichnet, dass die einen Schirm bildenden Mittel ein Gitter (4) pro Spalte in Form eines Bandes besitzen, das eine Reihe von Verbreiterungen und eine Öffnung im wesentlichen in der Mitte der Verbreiterung besitzt, wobei die Lesedioden (5), die in dem Halbleitersubstrat ausgebildet sind, in jeder der Öffnungen sitzen.

5. Vorrichtung nach Anspruch 4, dadurch gekennzeichnet, dass die Verbindungs- und Steuermittel ausserdem ein leitendes lichtundurchlässiges Band (7) aufweisen, das für jede Spalte oberhalb des Schirmgitters aufgebracht ist, mindestens so breit wie die Lesedioden ist und die elektrische Verbindung der in einer gemeinsamen Spalte angeordneten diskreten Lesedioden sichert.

6. Vorrichtung nach einem der Ansprüche 1 bis 5, dadurch gekennzeichnet, dass die Lesedioden (5) auf Lücke angeordnet sind.

7. Vorrichtung nach einem der Ansprüche 4 bis 6, dadurch gekennzeichnet, dass die Schirmgitter (4) jede der lichtempfindlichen Zonen im wesentlichen in deren Mitte durchqueren.

8. Lichtempfindliche Vorrichtung nach Anspruch 1, dadurch gekennzeichnet, dass die Lesedioden Banddioden (57) sind, die je nacheinander aufgrund der Steuerung die Ladungen von M Elementarzonen empfangen, welche N verschiedenen Zeilen angehören, wobei diese Lesedioden im Halbleitersubstrat unter jedem der Schirmgitter (47) ausgebildet sind und eine geringere Breite als diese Gitter besitzen.

9. Vorrichtung nach Anspruch 8, dadurch gekennzeichnet, dass sie ausserdem ein lichtundurchlässiges Band (77) besitzt, dessen Breite mindestens gleich der Breite der Lesedioden ist und das oberhalb des Schirmgitters für jede der Spalten angebracht ist.

10. Vorrichtung nach einem der Ansprüche 4 oder 8, dadurch gekennzeichnet, dass die gegenseitige Isolierung der lichtempfindlichen Zonen senkrecht in kontinuierlicher Weise zwischen zwei Schirmgittern im wesentlichen in der Mitte des Intervalls und waagerecht (20) zwischen zwei MOS-Kondensatorgittern kontinuierlich erfolgt, mit Ausnahme in Höhe der Lesedioden.

11. Vorrichtung nach Anspruch 10, dadurch gekennzeichnet, dass die Isolierung eine Verdickung (1) der isolierenden Schicht aufweist, mit der das Halbleitersubstrat bedeckt ist.

12. Vorrichtung nach Anspruch 10, dadurch gekennzeichnet, dass die Isolierung durch eine erhöhte Dotierung (57) des Halbleitersubstrats gebildet wird.

13. Vorrichtung nach Anspruch 11, dadurch gekennzeichnet, dass die Isolierung ausserdem eine erhöhte Dotierung des Substrats unterhalb der Verdickung aufweist.

14. Vorrichtung nach einem der vorhergehenden Ansprüche, dadurch gekennzeichnet, dass jede der zweiten Ladungssammelzonen (8) von einer Diode gebildet wird.

15. Vorrichtung nach Anspruch 14, dadurch gekennzeichnet, dass die Diode sich unter dem Gitter des MOS-Kondensators jeder lichtempfindlichen Zone erstreckt.

16. Vorrichtung nach einem der Ansprüche 4 oder 8 oder gemäss den Ansprüchen 4 und 14 oder 8 und 14, dadurch gekennzeichnet, dass jede lichtempfindliche Zone zwei Ladungssammelzonen aufweist, die in zwei in das Gitter des MOS-Kondensators eingebrachten Öffnungen liegen, und zwar dort, wo sie nicht vom Schirmgitter bedeckt ist.

17. Vorrichtung nach einem der Ansprüche 1 bis 15, dadurch gekennzeichnet, dass jede lichtempfindliche Zone Ladungssammelzonen aufweist, die an denjenigen Stellen der lichtempfindlichen Zone liegen, die vom Schirmgitter und vom Gitter des MOS-Kondensators freigelassen werden.

18. Vorrichtung nach einem der vorhergehenden Ansprüche, dadurch gekennzeichnet, dass die Verbindungs- und Steuermittel Adressiermittel zur Adressierung der N Zeilen besitzen, durch die jeweils nur eines der N Gitter von MOS-Kondensatoren ein Potential empfängt, mit dem die Ladungen vom MOS-Kondensator und den Ladungssammelzonen auf die Lesedioden übergehen.

19. Vorrichtung nach einem der Ansprüche 5 oder 9, dadurch gekennzeichnet, dass das lichtundurchlässige Band (7, 77) aus Aluminium hergestellt ist.

20. Vorrichtung zur Bildanalyse unter Verwendung des elektrischen Ladungstransfers mit:

– einer Matrix von N Zeilen zu je M lichtempfindlichen Elementarzonen;

– einem Speicher mit M Punkten, Zeilenspeicher genannt, der nacheinander die in jeder Zeile gespeicherten Ladungen empfängt;

– einem Schieberegister, das parallel den Inhalt des Zeilenspeichers empfängt und in Reihe ein elektrisches Signal ausgibt, das das Analysensignal des Bildes darstellt, dadurch gekennzeichnet, dass die lichtempfindliche Matrix eine Vorrichtung nach einem der vorhergehenden Ansprüche enthält.

# FIG_1

# FIG_5

**0 060 752**

FIG_2

FIG_3

FIG_4

# FIG_6

# FIG_7

Coupe CC

# FIG_8